# EUROPEAN PATENT APPLICATION

(11) **EP 4 621 850 A1**
(43) Date of publication of application: **24.09.2025**
(21) Application number: 23890169.8
(22) Date of filing: 21.06.2023
(51) Int. Cl.: H01L 29/06, H01L 29/16, H01L 21/205

(54) **SILICON CARBIDE EPITAXIAL WAFER, AND PREPARATION METHOD THEREFOR AND USE THEREOF**

(30) Priority: 14.11.2022 CN 202211422470
(71) Applicant: BYD Company Limited, Shenzhen, Guangdong 518118 (CN); BYD Auto Industry Company Limited, Guangdong 518118 (CN)
(72) Inventor: XIE, Chunlin, Shenzhen, Guangdong 518118 (CN); OU, Canlin, Shenzhen, Guangdong 518118 (CN); ZHOU, Wei, Shenzhen, Guangdong 518118 (CN)
(74) Representative: Mathys & Squire
(86) International application number: PCT/CN2023/101876
(87) International publication number: WO 2024/103727

(57) **Abstract**

The present disclosure relates to the field of semiconductor materials. Disclosed are a silicon carbide epitaxial wafer, and a preparation method therefor and a use thereof. The silicon carbide epitaxial wafer provided by the present disclosure has a structure of upper and lower doped silicon carbide epitaxial layers, and at least some of surface defects of the lower doped silicon carbide epitaxial layer are filled with intrinsic silicon carbide. Devices using the silicon carbide epitaxial wafer of the present disclosure have small leakage current, a low turn-on voltage, and are not prone to breakdown.

## Description

### CROSS-REFERENCE TO RELATED APPLICATIONS

This application claims priority of the patent application No. 202211422470.8 filed with the State Intellectual Property Office of China on November 14, 2022, and the entire contents of which are incorporated herein by reference.

### FIELD

The present disclosure relates to the field of semiconductor materials, and in particular to a silicon carbide epitaxial wafer and a preparation method and a use thereof.

### BACKGROUND

As a third-generation semiconductor material, silicon carbide has the advantages of wide band gap, high thermal conductivity, high critical breakdown field strength and high carrier saturation velocity. It can be widely used to produce high-power devices with high temperature, high frequency, and high voltage. It has incomparable advantages over traditional silicon materials in new energy vehicles and military industries. It is the core of new energy vehicles, new generation radars, and satellite communications, with important application value and broad development prospects, and has become the focus of attention in the current semiconductor industry. Especially as the development of silicon electronic components has reached its limits, researching third-generation wide band gap semiconductor materials has become more important and urgent, and will lead the third semiconductor industry revolution.

The thermal properties of silicon carbide are very stable, and the pyrolysis temperature is very high. Usually, the physical vapor transfer (PVT) method is used to slowly deposit silicon carbide ingots on silicon carbide seed chips, and then the substrate is made through crystal orientation, rounding, cutting, grinding, polishing and other processes. Then, high-temperature chemical vapor deposition (CVD) is used to grow n-type or p-type silicon carbide on the substrate to prepare epitaxial wafers, and finally, silicon carbide devices are prepared through processes such as photolithography, development, activation, and electrode deposition.

Silicon carbide devices require a very high standard for parameters such as surface morphology and defect density of the epitaxial layer, and the crystal quality of the silicon carbide epitaxial layer largely depends on the substrate. The defects of the substrate will continue to extend upwards during the epitaxial process. Therefore, epitaxial processing also requires a high standard for substrate defect density, and during the epitaxial growth process, some defects may occur due to parameters such as temperature, pressure, gas flow rate, and interface effects. Defects often become electron capture centers or generate leakage currents when the device is powered on, which greatly affects device performance. In the existing silicon carbide epitaxial structure and its manufacturing process, a layer of silicon carbide buffer layer is usually grown on the substrate first, followed by the growth of the silicon carbide epitaxial layer. Although the buffer layer has a certain inhibitory effect on defects, it is limited to the conversion of basal plane dislocations (BPD) defects. There are still a large number of defects in the epitaxial layer, such as carrot defects, triangle defects, threading screw dislocations (TSD), etc., which lead to high device leakage current, high turn-on voltage, and easy breakdown.

### SUMMARY

The purpose of this disclosure is to overcome the problems of high leakage current, high turn-on voltage, and easy breakdown of devices using silicon carbide epitaxial wafers in the prior art, and to provide a new silicon carbide epitaxial wafer and its preparation method and application. Devices using the silicon carbide epitaxial wafer disclosed in this disclosure have low leakage current, low turn-on voltage, and are not easy to breakdown.

In order to achieve the above objectives, the first aspect of the present disclosure provides a silicon carbide epitaxial wafer, wherein the epitaxial wafer has a structure of upper and lower doped silicon carbide epitaxial layers, and at least a portion of the surface defects of the lower doped silicon carbide epitaxial layer are filled with intrinsic silicon carbide.

The second aspect of the present disclosure provides a silicon carbide epitaxial wafer, wherein the epitaxial wafer includes a silicon carbide substrate, a first doped silicon carbide epitaxial layer formed on the silicon carbide substrate, and a second doped silicon carbide epitaxial layer formed on the first doped silicon carbide epitaxial layer, wherein at least a portion of the surface defects of the first doped silicon carbide epitaxial layer are filled with intrinsic silicon carbide.

Preferably, the silicon carbide epitaxial wafer further includes a doped silicon carbide buffer layer formed between the silicon carbide substrate and the first doped silicon carbide epitaxial layer.

Preferably, the thickness of the silicon carbide substrate is 300 to 1000 µm.

Preferably, the thickness of the doped silicon carbide buffer layer is 0.5 to 3.0 µm, the doping concentration is 5E17 to 5E18/cm², and the doping element is nitrogen; more preferably, the thickness of the doped silicon carbide buffer layer is 1.0 to 2.0 µm, the doping concentration is 1E18 to 3E18/cm², and the doping element is nitrogen.

Preferably, the silicon carbide epitaxial wafer further includes a third doped silicon carbide epitaxial layer formed between the doped silicon carbide buffer layer and the first doped silicon carbide epitaxial layer, and a graphene layer formed on the third doped silicon carbide epitaxial layer.

Preferably, the thickness of the third doped silicon carbide epitaxial layer is 1.0 to 20.0 µm, the doping concentration is 1E15 to 1E17/cm², and the doping element is nitrogen; more preferably, the thickness of the third doped silicon carbide epitaxial layer is 2.0 to 10.0 µm, the doping concentration is 2E15 to 1E16/cm², and the doping element is nitrogen; further preferred, the thickness of the third doped silicon carbide epitaxial layer is 5.0 to 10.0 µm, the doping concentration is 2E15 to 6E15/cm², and the doping element is nitrogen.

Preferably, the graphene layer is a graphene layer with 2 to 10 atomic layers.

Preferably, the thickness of the first doped silicon carbide epitaxial layer is 3.0 to 30.0 µm, the doping concentration is 1E15 to 1E17/cm², and the doping element is nitrogen; more preferably, the thickness of the first doped silicon carbide epitaxial layer is 3 to 25.0 µm, the doping concentration is 2E15 to 2E16/cm², and the doping element is nitrogen; further preferred, the thickness of the first doped silicon carbide epitaxial layer is 3.0 to 15.0 µm, the doping concentration is 6E15 to 2E16/cm², and the doping element is nitrogen; further preferably, the thickness of the first doped silicon carbide epitaxial layer is 3.0 to 8.0 µm, the doping concentration is 8E15 to 2E16/cm², and the doping element is nitrogen.

Preferably, the thickness of the second doped silicon carbide epitaxial layer is 2.0 to 25.0 µm, the doping concentration is 1E15 to 1E17/cm², and the doping element is nitrogen; more preferably, the thickness of the second doped silicon carbide epitaxial layer is 2.0 to 15.0 µm, the doping concentration is 4E15 to 1E16/cm², and the doping element is nitrogen; more preferably, the thickness of the second doped silicon carbide epitaxial layer is 2.0 to 10.0 µm, the doping concentration is 8E15 to 1E16/cm², and the doping element is nitrogen.

According to the third aspect of the present disclosure, a method for preparing a silicon carbide epitaxial wafer is provided, wherein the method includes the following steps,
1) depositing doped silicon carbide on a silicon carbide substrate by vapor deposition to form a first doped silicon carbide epitaxial layer;
2) in-situ etching the surface of the first doped silicon carbide epitaxial layer in a hydrogen atmosphere to form pits at surface defects;
3) depositing intrinsic silicon carbide on the surface of the first doped silicon carbide epitaxial layer after etching by vapor deposition;
4) removing the intrinsic silicon carbide outside the pit;
5) depositing doped silicon carbide by vapor deposition to form a second doped silicon carbide epitaxial layer.

Preferably, the method further includes: before forming the first doped silicon carbide epitaxial layer, depositing doped silicon carbide on the silicon carbide substrate by vapor deposition to form a doped silicon carbide buffer layer.

Preferably, the method further includes: after forming the doped silicon carbide buffer layer, depositing the original doped silicon carbide on the silicon carbide substrate by vapor deposition, and performing pyrolysis on the surface of the original doped silicon carbide away from the doped silicon carbide buffer layer at a temperature of 1400 to 1600°C to form a graphene layer, and forming a third doped silicon carbide epitaxial layer on the original doped silicon carbide that has not been subjected to pyrolysis.

Preferably, the thickness of the doped silicon carbide buffer layer is 0.5 to 3.0 µm, the doping concentration is 5E17 to 5E18/cm², and the doping element is nitrogen; more preferably, the thickness of the doped silicon carbide buffer layer is 1.0 to 2.0 µm, the doping concentration is 1E18 to 3E18/cm², and the doping element is nitrogen.

Preferably, the thickness of the third doped silicon carbide epitaxial layer is 1.0 to 20.0 µm, the doping concentration is 1E15 to 1E17/cm², and the doping element is nitrogen; more preferably, the thickness of the third doped silicon carbide epitaxial layer is 2.0 to 10.0 µm, the doping concentration is 2E15 to 1E16/cm², and the doping element is nitrogen; further preferred, the thickness of the third doped silicon carbide epitaxial layer is 5.0 to 10.0 µm, the doping concentration is 2E15 to 6E15/cm², and the doping element is nitrogen.

Preferably, the graphene layer is a graphene layer with 2 to 10 atomic layers.

Preferably, the thickness of the first doped silicon carbide epitaxial layer is 3.0 to 30.0 µm, the doping concentration is 1E15 to 1E17/cm², and the doping element is nitrogen; more preferably, the thickness of the first doped silicon carbide epitaxial layer is 3 to 25.0 µm, the doping concentration is 2E15 to 2E16/cm², and the doping element is nitrogen; further preferred, the thickness of the first doped silicon carbide epitaxial layer is 3.0 to 15.0 µm, the doping concentration is 6E15 to 2E16/cm², and the doping element is nitrogen; further preferably, the thickness of the first doped silicon carbide epitaxial layer is 3.0 to 8.0 µm, the doping concentration is 8E15 to 2E16/cm², and the doping element is nitrogen.

Preferably, the thickness of the second doped silicon carbide epitaxial layer is 2.0 to 25.0 µm, the doping concentration is 1E15 to 1E17/cm², and the doping element is nitrogen; more preferably, the thickness of the second doped silicon carbide epitaxial layer is 2.0 to 15.0 µm, the doping concentration is 4E15 to 1E16/cm², and the doping element is nitrogen; more preferably, the thickness of the second doped silicon carbide epitaxial layer is 2.0 to 10.0 µm, the doping concentration is 8E15 to 1E16/cm², and the doping element is nitrogen.

Preferably, in step 2), the etching time is 5 to 20 minutes.

Preferably, in step 4), in-situ hydrogen etching or chemical polishing is used to remove intrinsic silicon carbide outside of the pits.

Preferably, the conditions for vapor deposition include a temperature of 1500 to 1700°C and a pressure of 50 to 200 mbar.

According to the fourth aspect of this disclosure, a use of the silicon carbide epitaxial wafer described in the first and second aspects of the present disclosure in preparing a silicon carbide power device is provided.

Through the above technical solution, the disclosed silicon carbide epitaxial wafer introduces intrinsic silicon carbide at the defect position during the epitaxial growth process. By utilizing the poor conductivity of intrinsic silicon carbide, the transport of charge carriers at the defect position is reduced, thereby avoiding charge carrier capture by defects. As a result, devices using the disclosed silicon carbide epitaxial wafer have low leakage current, low turn-on voltage, and are not easily broken down.

### BRIEF DESCRIPTION OF THE DRAWINGS

FIG. 1 is a schematic structural diagram of a silicon carbide epitaxial wafer according to an embodiment of the present disclosure.
FIG. 2 is a schematic structural diagram of a silicon carbide epitaxial wafer according to another embodiment of the present disclosure.

### Explanation of the reference numerals

1: silicon carbide substrate; 2: doped silicon carbide buffer layer; 3: first doped silicon carbide epitaxial layer; 4: second doped silicon carbide epitaxial layer; 5: intrinsic silicon carbide; 6: third doped silicon carbide epitaxial layer; 7: graphene layer.

### DETAILED DESCRIPTION

The endpoints and any values disclosed in this article are not limited to the exact range or value, and these ranges or values should be understood as including values close to these ranges or values. For numerical ranges, the endpoint values of each range, the endpoint values of each range and individual point values, and individual point values can be combined with each other to obtain one or more new numerical ranges, which should be considered as specifically disclosed in this article.

According to the first aspect of the present disclosure, a silicon carbide epitaxial wafer is provided, wherein the epitaxial wafer has a structure of upper and lower doped silicon carbide epitaxial layers, and at least a portion of the surface defects of the lower doped silicon carbide epitaxial layer are filled with intrinsic silicon carbide.

The disclosed silicon carbide epitaxial wafer introduces intrinsic silicon carbide at defect locations during epitaxial growth, utilizing the poor conductivity of intrinsic silicon carbide to reduce the transport of charge carriers at defect locations, thereby avoiding charge carrier capture by defects. As a result, devices using the disclosed silicon carbide epitaxial wafer have low leakage current, low turn-on voltage, and are less prone to breakdown.

Preferably, all surface defects of the lower doped silicon carbide epitaxial layer are filled with intrinsic silicon carbide.

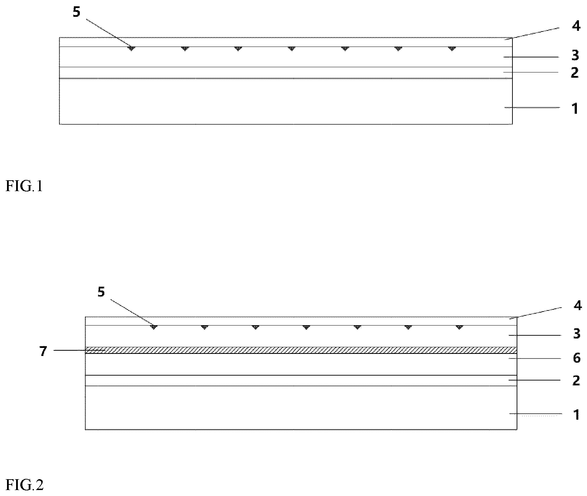

According to the second aspect of the present disclosure, a silicon carbide epitaxial wafer is provided, as shown in Fig. 1, the epitaxial wafer includes a silicon carbide substrate 1, a first doped silicon carbide epitaxial layer 3 formed on the silicon carbide substrate 1, and a second doped silicon carbide epitaxial layer 4 formed on the first doped silicon carbide epitaxial layer 3, wherein at least a portion of the surface defects of the first doped silicon carbide epitaxial layer 3 are filled with intrinsic silicon carbide 5. Intrinsic silicon carbide refers to undoped silicon carbide.

According to the present disclosure, there are no specific limitations on the silicon carbide substrate, which can be prepared using common methods in this field, such as slowly depositing silicon carbide ingots on silicon carbide seed chips using physical vapor transfer (PVT), and then producing the substrate through crystal orientation, rolling, cutting, grinding, polishing, and other processes.

The thickness of the silicon carbide substrate is 300 to 1000 µm, preferably 400 to 500 µm.

In the present disclosure, as shown in Fig. 1, in order to reduce the surface defects of the doped silicon carbide epitaxial layer, it is preferred that a doped silicon carbide buffer layer 2 is formed on the silicon carbide substrate. Preferably, the thickness of the doped silicon carbide buffer layer 2 is 0.5 to 3.0 µm, the doping concentration is 5E17 to 5E18/cm², and the doping element is nitrogen; more preferably, the thickness of the doped silicon carbide buffer layer 2 is 1.0 to 2.0 µm, the doping concentration is 1E18 to 3E18/cm², and the doping element is nitrogen.

In another preferred embodiment of the present disclosure, as shown in Fig. 2, preferably, the silicon carbide epitaxial wafer further includes a third doped silicon carbide epitaxial layer 6 formed between the doped silicon carbide buffer layer 2 and the first doped silicon carbide epitaxial layer 3 and a graphene layer 7 formed on the third doped silicon carbide epitaxial layer 6.

Preferably, the thickness of the third doped silicon carbide epitaxial layer is 1.0 to 20.0 µm, the doping concentration is 1E15 to 1E17/cm², and the doping element is nitrogen; more preferably, the thickness of the third doped silicon carbide epitaxial layer is 2.0 to 10.0 µm, the doping concentration is 2E15 to 1E16/cm², and the doping element is nitrogen; further preferred, the thickness of the third doped silicon carbide epitaxial layer is 5.0 to 10.0 µm, the doping concentration is 2E15 to 6E15/cm², and the doping element is nitrogen.

As a specific example of the thickness of the third doped silicon carbide epitaxial layer, examples include: 1.0 µm, 2.0 µm, 3.0 µm, 4.0 µm, 5.0 µm, 6.0 µm, 7.0 µm, 8.0 µm, 9.0 µm, 10.0 µm, 11.0 µm, 12.0 µm, 13.0 µm, 14.0 µm, 15.0 µm, 16.0 µm, 17.0 µm, 18.0 µm, 19.0 µm, 20.0 µm, etc., and ranges formed by any two of the above values.

As a specific example of the doping concentration of the third doped silicon carbide epitaxial layer, for example, 1E15/cm², 2E15/cm², 3E15/cm², 4E15/cm², 5E15/cm², 6E15/cm², 7E15/cm², 8E15/cm², 9E15/cm², 1E16/cm², 2E16/cm², 3E16/cm², 4E16/cm², 5E16/cm², 6E16/cm², 7E16/cm², 8E16/cm², 9E16/cm², 1E17/cm², etc., and ranges formed by any two of the above values.

In this disclosure, a graphene layer is formed on the third doped silicon carbide epitaxial layer. Preferably, the graphene layer is a graphene layer with 2 to 10 atomic layers.

According to this disclosure, by forming graphene layers and utilizing the high transverse electron mobility of graphene, the uniformity of current can be improved.

Those skilled in the art should understand that, when the doped silicon carbide buffer layer, the third doped silicon carbide epitaxial layer and the graphene layer are not formed, the first doped silicon carbide epitaxial layer is formed on the silicon carbide substrate; when the doped silicon carbide buffer layer is formed and the third doped silicon carbide epitaxial layer and the graphene layer are not formed, the first doped silicon carbide epitaxial layer is formed on the doped silicon carbide buffer layer; when the doped silicon carbide buffer layer, the third doped silicon carbide epitaxial layer and the graphene layer are formed, the first doped silicon carbide epitaxial layer is formed on the graphene layer.

In this disclosure, it is preferred that the thickness of the first doped silicon carbide epitaxial layer is 3.0 to 30.0 µm, the doping concentration is 1E15 to 1E17/cm², and the doping element is nitrogen; more preferably, the thickness of the first doped silicon carbide epitaxial layer is 3 to 25.0 µm, the doping concentration is 2E15 to 2E16/cm², and the doping element is nitrogen; further preferred, the thickness of the first doped silicon carbide epitaxial layer is 3.0 to 15.0 µm, the doping concentration is 6E15 to 2E16/cm², and the doping element is nitrogen; further preferably, the thickness of the first doped silicon carbide epitaxial layer is 3.0 to 8.0 µm, the doping concentration is 8E15 to 2E16/cm², and the doping element is nitrogen.

As a specific example of the thickness of the first doped silicon carbide epitaxial layer, for example: 3.0 µm, 4.0 µm, 5.0 µm, 6.0 µm, 7.0 µm, 8.0 µm, 9.0 µm, 10.0 µm, 11.0 µm, 12.0 µm, 13.0 µm, 14.0 µm, 15.0 µm, 16.0 µm, 17.0 µm, 18.0 µm, 19.0 µm, 20.0 µm, 21.0 µm, 22.0 µm, 23.0 µm, 24.0 µm, 25.0 µm, 26.0 µm, 27.0 µm, 28.0 µm, 29.0 µm, 30.0 µm, etc., and ranges formed by any two of the above values.

As a specific example of the doping concentration of the first doped silicon carbide epitaxial layer, for example, 1E15/cm², 2E15/cm², 3E15/cm², 4E15/cm², 5E15/cm², 6E15/cm², 7E15/cₘ², 8E15/cm², 9E15/cm², 1E16/cm², 2E16/cm², 3E16/cm², 4E16/cm², 5E16/cm², 6E16/cm², 7E16/cm², 8E16/cm², 9E16/cm², 1E17/cm², etc., and ranges formed by any two of the above values.

In this disclosure, a second doped silicon carbide epitaxial layer is formed on the first doped silicon carbide epitaxial layer. Preferably, the thickness of the second doped silicon carbide epitaxial layer is 2.0 to 25.0 µm, the doping concentration is 1E15 to 1E17/cm², and the doping element is nitrogen; more preferably, the thickness of the second doped silicon carbide epitaxial layer is 2.0 to 15.0 µm, the doping concentration is 4E15 to 1E16/cm², and the doping element is nitrogen; further preferred, the thickness of the second doped silicon carbide epitaxial layer is 2.0 to 10.0 µm, the doping concentration is 8E15 to 1E16/cm², and the doping element is nitrogen.

As a specific example of the thickness of the second doped silicon carbide epitaxial layer, for example: 2.0 µm, 3.0 µm, 4.0 µm, 5.0 µm, 6.0 µm, 7.0 µm, 8.0 µm, 9.0 µm, 10.0 µm, 11.0 µm, 12.0 µm, 13.0 µm, 14.0 µm, 15.0 µm, 16.0 µm, 17.0 µm, 18.0 µm, 19.0 µm, 20.0 µm, 21.0 µm, 22.0 µm, 23.0 µm, 24.0 µm, 25.0 µm, etc., and ranges formed by any two of the above values.

As a specific example of the doping concentration of the second doped silicon carbide epitaxial layer, for example, 1E15/cm², 2E15/cm², 3E15/cm², 4E15/cm², 5E15/cm², 6E15/cm², 7E15/cₘ², 8E15/cm², 9E15/cm², 1E16/cm², 2E16/cm², 3E16/cm², 4E16/cm², 5E16/cm², 6E16/cm², 7E16/cm², 8E16/cm², 9E16/cm², 1E17/cm², etc., and ranges formed by any two of the above values.

In this disclosure, preferably, all surface defects of the first doped silicon carbide epitaxial layer are filled with intrinsic silicon carbide.

According to the third aspect of the present disclosure, a method for preparing a silicon carbide epitaxial wafer is provided, wherein the method includes the following steps,
1) depositing doped silicon carbide on a silicon carbide substrate by vapor deposition to form a first doped silicon carbide epitaxial layer;
2) in-situ etching the surface of the first doped silicon carbide epitaxial layer in a hydrogen atmosphere to form pits at surface defects;
3) depositing intrinsic silicon carbide on the surface of the first doped silicon carbide epitaxial layer after etching by vapor deposition;
4) removing the intrinsic silicon carbide outside the pit;
5) depositing doped silicon carbide by vapor deposition to form a second doped silicon carbide epitaxial layer.

According to this disclosure, the silicon carbide substrate is as described above. In order to reduce the defects on the surface of the doped silicon carbide epitaxial layer, the preferred method of this disclosure further includes the step of depositing doped silicon carbide on the silicon carbide substrate by vapor deposition to form a doped silicon carbide buffer layer before forming the first doped silicon carbide epitaxial layer.

Preferably, the thickness of the doped silicon carbide buffer layer is 0.5 to 3 µm, the doping concentration is 5E17 to 5E18/cm², and the doping element is nitrogen; more preferably, the thickness of the doped silicon carbide buffer layer is 1.0 to 2.0 µm, the doping concentration is 1E18 to 3E18/cm², and the doping element is nitrogen.

According to this disclosure, preferably, the method of this disclosure further includes: after forming the doped silicon carbide buffer layer, depositing the original doped silicon carbide on the silicon carbide substrate by vapor deposition, and pyrolysis the surface of the original doped silicon carbide away from the doped silicon carbide buffer layer at a temperature of 1400 to 1600°C, thereby forming a graphene layer on the surface of the original doped silicon carbide away from the doped silicon carbide buffer layer. The above-mentioned original doped silicon carbide that has not been decomposed by high temperature forms a third doped silicon carbide epitaxial layer.

Specific temperatures include, for example, 1400°C, 1450°C, 1500°C, 1550°C, 1600°C, etc., and ranges formed by any two of the above values.

Preferably, the thickness of the third doped silicon carbide epitaxial layer is 1.0 to 20.0 µm, the doping concentration is 1E15 to 1E17/cm², and the doping element is nitrogen; more preferably, the thickness of the third doped silicon carbide epitaxial layer is 2.0 to 10.0 µm, the doping concentration is 2E15 to 1E16/cm², and the doping element is nitrogen; further preferred, the thickness of the third doped silicon carbide epitaxial layer is 5.0 to 10.0 µm, the doping concentration is 2E15 to 6E15/cm², and the doping element is nitrogen.

As a specific example of the thickness of the third doped silicon carbide epitaxial layer, for example: 1.0 µm, 2.0 µm, 3.0 µm, 4.0 µm, 5.0 µm, 6.0 µm, 7.0 µm, 8.0 µm, 9.0 µm, 10.0 µm, 11.0 µm, 12.0 µm, 13.0 µm, 14.0 µm, 15.0 µm, 16.0 µm, 17.0 µm, 18.0 µm, 19.0 µm, 20.0 µm, etc., and ranges formed by any two of the above values.

As a specific example of the doping concentration of the third doped silicon carbide epitaxial layer, for example, 1E15/cm², 2E15/cm², 3E15/cm², 4E15/cm², 5E15/cm², 6E15/cm², 7E15/cₘ², 8E15/cm², 9E15/cm², 1E16/cm², 2E16/cm², 3E16/cm², 4E16/cm², 5E16/cm², 6E16/cm², 7E16/cm², 8E16/cm², 9E16/cm², 1E17/cm², etc., and ranges formed by any two of the above values.

In the present disclosure, the graphene layer is formed by pyrolyzing the surface of the third doped silicon carbide epitaxial layer at a temperature of 1400 to 1600°C

The pyrolysis time may be, for example, 2 to 10 minutes, preferably 3 to 5 minutes, and specific times may include, for example, 2 minutes, 3 minutes, 4 minutes, 5 minutes, 6 minutes, 7 minutes, 8 minutes, 9 minutes, 10 minutes, etc., and ranges formed by any two of the above values.

According to the present disclosure, by pyrolyzing the surface of the third doped silicon carbide epitaxial layer at a temperature of 1400 to 1600° C, Si elements are separated and C elements remain in place, thereby forming a graphene layer. Preferably, the graphene layer is a graphene layer of 2 to 10 atomic layers.

Those skilled in the art should understand that, when the doped silicon carbide buffer layer, the third doped silicon carbide epitaxial layer and the graphene layer are not formed, the first doped silicon carbide epitaxial layer is formed on the silicon carbide substrate by vapor deposition; when the doped silicon carbide buffer layer is formed and the third doped silicon carbide epitaxial layer and the graphene layer are not formed, the first doped silicon carbide epitaxial layer is formed on the doped silicon carbide buffer layer by vapor deposition; when the doped silicon carbide buffer layer, the third doped silicon carbide epitaxial layer and the graphene layer are formed, the first doped silicon carbide epitaxial layer is formed on the graphene layer by vapor deposition.

In this disclosure, it is preferred that the thickness of the first doped silicon carbide epitaxial layer is 3.0 to 30.0 µm, the doping concentration is 1E15 to 1E17/cm², and the doping element is nitrogen; more preferably, the thickness of the first doped silicon carbide epitaxial layer is 3 to 25.0 µm, the doping concentration is 2E15 to 2E16/cm², and the doping element is nitrogen; further preferred, the thickness of the first doped silicon carbide epitaxial layer is 3.0 to 15.0 µm, the doping concentration is 6E15 to 2E16/cm², and the doping element is nitrogen; further preferably, the thickness of the first doped silicon carbide epitaxial layer is 3.0 to 8.0 µm, the doping concentration is 8E15 to 2E16/cm², and the doping element is nitrogen.

As a specific example of the thickness of the first doped silicon carbide epitaxial layer, for example: 3.0 µm, 4.0 µm, 5.0 µm, 6.0 µm, 7.0 µm, 8.0 µm, 9.0 µm, 10.0 µm, 11.0 µm, 12.0 µm, 13.0 µm, 14.0 µm, 15.0 µm, 16.0 µm, 17.0 µm, 18.0 µm, 19.0 µm, 20.0 µm, 21.0 µm, 22.0 µm, 23.0 µm, 24.0 µm, 25.0 µm, 26.0 µm, 27.0 µm, 28.0 µm, 29.0 µm, 30.0 µm, etc., and ranges formed by any two of the above values.

As a specific example of the doping concentration of the first doped silicon carbide epitaxial layer, for example, 1E15/cm², 2E15/cm², 3E15/cm², 4E15/cm², 5E15/cm², 6E15/cm², 7E15/cₘ², 8E15/cm², 9E15/cm², 1E16/cm², 2E16/cm², 3E16/cm², 4E16/cm², 5E16/cm², 6E16/cm², 7E16/cm², 8E16/cm², 9E16/cm², 1E17/cm², etc., and ranges formed by any two of the above values.

In this disclosure, pits are formed at surface defects by in-situ etching the surface of the first doped silicon carbide epitaxial layer in a hydrogen atmosphere. Specifically, due to the fast etching rate at the defect location, pits are prone to form at the defect site.

Preferably, the etching conditions include: a temperature of 1500 to 1700°C and a time of 5 to 20 minutes; more preferably, the etching conditions include: a temperature of 1550 to 1650°C and a time of 10 to 15 minutes.

The shape of the above-mentioned pits can be one or more of V-shaped pits, cylindrical pits, and strip-shaped pits.

In this disclosure, intrinsic silicon carbide is deposited on the surface of the first doped silicon carbide epitaxial layer after etching by vapor deposition. By depositing intrinsic silicon carbide, pits can be filled and a flat silicon carbide surface can be obtained.

As for the thickness of intrinsic silicon carbide deposited as mentioned above, as long as it can fill the pits, it is sufficient. For ease of operation, it is preferred that intrinsic silicon carbide is also deposited in the part outside the pits. In this case, the intrinsic silicon carbide outside the pits can be removed, thereby obtaining a first doped silicon carbide epitaxial layer with a flat surface and surface pits filled with intrinsic silicon carbide.

The specific thickness of the deposited intrinsic silicon carbide may be, for example, 0.2 to 2 µm, preferably 0.3 to 1 µm, and more preferably 0.3 to 0.5 µm.

There is no particular limitation on the method for removing the intrinsic silicon carbide other than the pits, and the method can be performed by in-situ hydrogen etching or chemical polishing commonly used in the art.

In this disclosure, doped silicon carbide is further deposited by vapor deposition to form a second doped silicon carbide epitaxial layer. Preferably, the thickness of the second doped silicon carbide epitaxial layer is 2.0 to 25.0 µm, the doping concentration is 1E15 to 1E17/cm², and the doping element is nitrogen; more preferably, the thickness of the second doped silicon carbide epitaxial layer is 2.0 to 15.0 µm, the doping concentration is 4E15 to 1E16/cm², and the doping element is nitrogen; further preferred, the thickness of the second doped silicon carbide epitaxial layer is 2.0 to 10.0 µm, the doping concentration is 8E15 to 1E16/cm², and the doping element is nitrogen.

As a specific example of the thickness of the second doped silicon carbide epitaxial layer, for example: 2.0 µm, 3.0 µm, 4.0 µm, 5.0 µm, 6.0 µm, 7.0 µm, 8.0 µm, 9.0 µm, 10.0 µm, 11.0 µm, 12.0 µm, 13.0 µm, 14.0 µm, 15.0 µm, 16.0 µm, 17.0 µm, 18.0 µm, 19.0 µm, 20.0 µm, 21.0 µm, 22.0 µm, 23.0 µm, 24.0 µm, 25.0 µm, etc., and ranges formed by any two of the above values.

As specific examples of the doping concentration of the second doped silicon carbide epitaxial layer, for example, 1E15/cm², 2E15/cm², 3E15/cm², 4E15/cm², 5E15/cm², 6E15/cm², 7E15/cm², 8E15/cm², 9E15/cm², 1E16/cm², 2E16/cm², 3E16/cm², 4E16/cm², 5E16/cm², 6E16/cm², 7E16/cm², 8E16/cm², 9E16/cm², 1E17/cm², etc., and ranges formed by any two of the above values.

In addition, the vapor deposition conditions in the above steps may include: a temperature of 1500 to 1700° C., a pressure of 50 to 200 mbar, and a deposition time based on obtaining a target thickness.

According to the fourth aspect of this disclosure, a use of the silicon carbide epitaxial wafer described in the first and second aspects of the present disclosure in preparing a silicon carbide power device is provided.

The present disclosure will be described in detail below through examples, but the present disclosure is not limited to the following examples.

In the following examples, the silicon carbide substrate is purchased from CREE in the United States with a thickness of 430 µm.

### Example 1

1) depositing doped silicon carbide (with a thickness of 1.0 µm, a doping concentration of 1E18/cm², and nitrogen as the doping element) on a silicon carbide substrate by vapor deposition to form a doped silicon carbide buffer layer;
2) depositing doped silicon carbide (with a thickness of 6.0 µm, a doping concentration of 1E16/cm², and nitrogen as the doping element) on the doped silicon carbide buffer layer by vapor deposition to form a first doped silicon carbide epitaxial layer;
3) in-situ etching the surface of the first doped silicon carbide epitaxial layer in a hydrogen atmosphere at a temperature of 1600°C for 15 minutes to form pits at surface defects;
4) depositing intrinsic silicon carbide (with a thickness of 0.5 µm) on the surface of the etched first doped silicon carbide epitaxial layer by vapor deposition to obtain a flat silicon carbide surface;
5) using in-situ hydrogen etching to remove the intrinsic silicon carbide outside the pit, the etching temperature is 1600°C, and the etching time is 10 minutes;
6) depositing doped silicon carbide (thickness of 5.0 µm, doping concentration of 1E16/cm², and nitrogen as the doping element) by vapor deposition to form a second doped silicon carbide epitaxial layer, thereby obtaining a silicon carbide epitaxial wafer A1.

### Example 2

1) depositing doped silicon carbide (with a thickness of 1.0 µm, a doping concentration of 2E18/cm², and nitrogen as the doping element) on a silicon carbide substrate by vapor deposition to form a doped silicon carbide buffer layer;
2) depositing doped silicon carbide (with a thickness of 3.0 µm, a doping concentration of 2E16/cm², and nitrogen as the doping element) on the doped silicon carbide buffer layer by vapor deposition to form a first doped silicon carbide epitaxial layer;
3) in-situ etching the surface of the first doped silicon carbide epitaxial layer in a hydrogen atmosphere at a temperature of 1600° C. for 15 minutes to form pits at surface defects;
4) depositing intrinsic silicon carbide (with a thickness of 0.5 µm) on the surface of the first doped silicon carbide epitaxial layer after etching by vapor deposition to obtain a flat silicon carbide surface;
5) using in-situ hydrogen etching to remove the intrinsic silicon carbide outside the pit, the etching temperature is 1600°C, and the etching time is 10 minutes;
6) depositing doped silicon carbide (thickness of 2.0 µm, doping concentration of 5E15/cm², and nitrogen as the doping element) by vapor deposition to form a second doped silicon carbide epitaxial layer, thereby obtaining a silicon carbide epitaxial wafer A2.

### Example 3

1) depositing doped silicon carbide (with a thickness of 1.0 µm, a doping concentration of 3E18/cm², and nitrogen as the doping element) on a silicon carbide substrate by vapor deposition to form a doped silicon carbide buffer layer;
2) depositing doped silicon carbide (with a thickness of 8 µm, a doping concentration of 8E15/cm², and nitrogen as the doping element) on the doped silicon carbide buffer layer by vapor deposition to form a first doped silicon carbide epitaxial layer;
3) in-situ etching the surface of the first doped silicon carbide epitaxial layer in a hydrogen atmosphere at a temperature of 1600°C for 15 minutes to form pits at surface defects;
4) depositing intrinsic silicon carbide (with a thickness of 0.5 µm) on the surface of the first doped silicon carbide epitaxial layer after etching by vapor deposition to obtain a flat silicon carbide surface;
5) using in-situ hydrogen etching to remove the intrinsic silicon carbide outside the pit, the etching temperature is 1600°C, and the etching time is 10 minutes;
6) depositing doped silicon carbide (thickness of 10 µm, doping concentration of 8E15/cm², and nitrogen as the doping element) by vapor deposition to form a second doped silicon carbide epitaxial layer, thereby obtaining a silicon carbide epitaxial wafer A3.

### Example 4

1) depositing doped silicon carbide (with a thickness of 1.0 µm, a doping concentration of 1E18/cm², and nitrogen as the doping element) on a silicon carbide substrate by vapor deposition to form a doped silicon carbide buffer layer;
2) depositing doped silicon carbide (with a thickness of 3.0 µm, a doping concentration of 1E16/cm², and nitrogen as the doping element) on the doped silicon carbide buffer layer by vapor deposition;
3) performing pyrolysis of the surface of the doped silicon carbide formed in step 2) away from the doped silicon carbide buffer layer at a temperature of 1400° C. (pyrolysis time is 6 minutes), and observation by transmission electron microscopy shows that a graphene layer of 4 to 6 atomic layers is formed; the doped silicon carbide that is not decomposed by high temperature forms a third doped silicon carbide epitaxial layer;
4) depositing doped silicon carbide (with a thickness of 5.0 µm, a doping concentration of 1E16/cm², and nitrogen as the doping element) on the graphene layer by vapor deposition to form a first doped silicon carbide epitaxial layer;
5) in-situ etching the surface of the first doped silicon carbide epitaxial layer in a hydrogen atmosphere at an etching temperature of 1600°C for 15 minutes to form pits at surface defects;
6) depositing intrinsic silicon carbide (with a thickness of 0.5 µm) on the surface of the first doped silicon carbide epitaxial layer after etching by vapor deposition to obtain a flat silicon carbide surface;
7) using in-situ hydrogen etching to remove the intrinsic silicon carbide outside the pit, the etching temperature is 1600°C, and the etching time is 10 minutes;
8) depositing doped silicon carbide (thickness of 3.0 µm, doping concentration of 1E16/cm², doping element of nitrogen) by vapor deposition to form a second doped silicon carbide epitaxial layer, thereby obtaining a silicon carbide epitaxial wafer A4.

### Example 5

1) depositing doped silicon carbide (with a thickness of 2.0 µm, a doping concentration of 1E18/cm², and nitrogen as the doping element) on a silicon carbide substrate by vapor deposition to form a doped silicon carbide buffer layer;
2) depositing doped silicon carbide (with a thickness of 5.0 µm, a doping concentration of 4E15/cm², and nitrogen as the doping element) on the doped silicon carbide buffer layer by vapor deposition;
3) performing pyrolysis of the surface of the doped silicon carbide formed in step 2) away from the doped silicon carbide buffer layer at a temperature of 1400°C (pyrolysis time is 5 minutes), and observing by transmission electron microscopy, it can be seen that a graphene layer of 4 to 10 atomic layers is formed; the above-mentioned doped silicon carbide that has not been decomposed by high temperature forms a third doped silicon carbide epitaxial layer;
4) depositing doped silicon carbide (with a thickness of 18 µm, a doping concentration of 4E15/cm², and nitrogen as the doping element) on the graphene layer by vapor deposition to form a first doped silicon carbide epitaxial layer;
5) in-situ etching the surface of the first doped silicon carbide epitaxial layer in a hydrogen atmosphere at an etching temperature of 1600°C for 15 minutes to form pits at surface defects;
6) depositing intrinsic silicon carbide (with a thickness of 0.5 µm) on the surface of the first doped silicon carbide epitaxial layer after etching by vapor deposition to obtain a flat silicon carbide surface;
7) using in-situ hydrogen etching to remove the intrinsic silicon carbide outside the pit, the etching temperature is 1600°C, and the etching time is 10 minutes;
8) depositing doped silicon carbide (thickness of 12.0 µm, doping concentration of 4E15/cm², and nitrogen as the doping element) by vapor deposition to form a second doped silicon carbide epitaxial layer, thereby obtaining a silicon carbide epitaxial wafer A5.

### Example 6

1) depositing doped silicon carbide (with a thickness of 2.0 µm, a doping concentration of 1E18/cm², and nitrogen as the doping element) on a silicon carbide substrate by vapor deposition to form a doped silicon carbide buffer layer;
2) depositing doped silicon carbide (with a thickness of 10.0 µm, a doping concentration of 2E15/cm², and nitrogen as the doping element) on the doped silicon carbide buffer layer by vapor deposition;
3) performing pyrolysis of the surface of the doped silicon carbide formed in step 2) away from the doped silicon carbide buffer layer at a temperature of 1600°C (pyrolysis time is 15 minutes), and observing by transmission electron microscopy, it can be seen that a graphene layer of 4 to 10 atomic layers is formed; the doped silicon carbide that is not decomposed by high temperature forms a third doped silicon carbide epitaxial layer;
4) depositing doped silicon carbide (with a thickness of 25.0 µm, a doping concentration of 2E15/cm², and nitrogen as the doping element) on the graphene layer by vapor deposition to form a first doped silicon carbide epitaxial layer;
5) in-situ etching the surface of the first doped silicon carbide epitaxial layer in a hydrogen atmosphere at an etching temperature of 1600°C for 15 minutes to form pits at surface defects;
6) depositing intrinsic silicon carbide (with a thickness of 0.5 µm) on the surface of the first doped silicon carbide epitaxial layer after etching by vapor deposition to obtain a flat silicon carbide surface;
7) using in-situ hydrogen etching to remove the intrinsic silicon carbide outside the pit, the etching temperature is 1600°C, and the etching time is 10 minutes;
8) depositing doped silicon carbide (thickness of 25.0 µm, doping concentration of 2E15/cm², and nitrogen as the doping element) by vapor deposition to form a second doped silicon carbide epitaxial layer, thereby obtaining a silicon carbide epitaxial wafer A6.

### Comparative Example 1

The method of Example 1 is followed, except that steps 3) to 5) are not performed, and a second doped silicon carbide epitaxial layer is directly formed on the first doped silicon carbide epitaxial layer, with a growth thickness of 10 µm and a doping concentration of 1E16; thereby, a silicon carbide epitaxial wafer D1 is obtained.

### Test Example 1

The silicon carbide epitaxial wafers A1 to A6 and D1 obtained in Examples 1 to 6 and Comparative Example 1 are used respectively, and three electrodes of gate, source and drain are prepared on the epitaxial wafers by photolithography, coating and other processes to prepare silicon carbide MOS tubes. A semiconductor discrete device static tester is used to fix the voltage between the gate and the source to test the leakage current between the gate and the source; and to fix the voltage between the drain and the source to test the turn-on voltage between the gate and the source; and to fix the voltage between the gate and the source to 0 to test the breakdown voltage between the drain and the source; the results are shown in Table 1.

**Table 1**

| | Leakage current (unit: µ A) | Threshold voltage (V) | Breakdown voltage (V) |
|---|---|---|---|
| A1 | 0.5 | 2.8 | 1500 |
| A2 | 0.3 | 2.6 | 650 |
| A3 | 0.8 | 3.2 | 1800 |
| A4 | 0.4 | 2.75 | 1600 |
| A5 | 2.0 | 3.9 | 3000 |
| A6 | 3.0 | 4.5 | 3500 |
| D1 | 5.0 | 5.0 | 1200 |

Embodiments A1, A4 and D1 have the same epitaxial layer thickness and carrier concentration, wherein comparative example D1 is an ordinary epitaxial layer structure, A1 includes a structure of a first epitaxial layer and a second epitaxial layer, and A4 includes a structure of a first epitaxial layer, a second epitaxial layer, and a third epitaxial layer. It can be seen from the test data in Table 1 that compared with D1, A1 and A4 have smaller leakage current, smaller turn-on voltage, and larger breakdown voltage, indicating that compared with the existing ordinary epitaxial layer structure, the structure disclosed in the present invention can significantly reduce the leakage current and turn-on voltage, and significantly increase the breakdown voltage.

In addition, by comparing A1 and A4, it can be seen that A4, which includes a first epitaxial layer, a second epitaxial layer, and a third epitaxial layer structure, can further reduce the leakage current and the turn-on voltage, and increase the breakdown voltage.

The preferred embodiments of the present disclosure are described in detail above, but the present disclosure is not limited thereto. Within the technical concept of the present disclosure, the technical solution of the present disclosure can be subjected to a variety of simple modifications, including combining various technical features in any other suitable manner, and these simple modifications and combinations should also be regarded as the contents disclosed by the present disclosure and belong to the protection scope of the present disclosure.

## Claims

1. A silicon carbide epitaxial wafer, wherein the epitaxial wafer comprises a silicon carbide substrate, a first doped silicon carbide epitaxial layer formed on the silicon carbide substrate, and a second doped silicon carbide epitaxial layer formed on the first doped silicon carbide epitaxial layer, wherein at least a portion of the surface defects of the first doped silicon carbide epitaxial layer are filled with intrinsic silicon carbide.

2. The silicon carbide epitaxial wafer according to claim 1, wherein the silicon carbide epitaxial wafer further comprises a doped silicon carbide buffer layer formed between the silicon carbide substrate and the first doped silicon carbide epitaxial layer.

3. The silicon carbide epitaxial wafer according to claim 1 or 2, wherein the thickness of the silicon carbide substrate is 300 to 1000 µm.

4. The silicon carbide epitaxial wafer according to claim 2 or 3, wherein the thickness of the doped silicon carbide buffer layer is 0.5 to 3.0 µm, the doping concentration is 5E17 to 5E18/cm², and the doping element is nitrogen.

5. The silicon carbide epitaxial wafer according to any one of claims 2 to 4, wherein the silicon carbide epitaxial wafer further comprises a third doped silicon carbide epitaxial layer formed between the doped silicon carbide buffer layer and the first doped silicon carbide epitaxial layer, and a graphene layer forming the third doped silicon carbide epitaxial layer away from the surface of the doped silicon carbide buffer layer.

6. The silicon carbide epitaxial wafer according to claim 5, wherein the thickness of the third doped silicon carbide epitaxial layer is 1.0 to 20.0 µm, the doping concentration is 1E15 to 1E17/cm², and the doping element is nitrogen.

7. The silicon carbide epitaxial wafer according to claim 5, wherein the graphene layer is a graphene layer with 2 to 10 atomic layers.

8. The silicon carbide epitaxial wafer according to any one of claims 1 to 7, wherein the thickness of the first doped silicon carbide epitaxial layer is 3.0 to 30.0 µm, the doping concentration is 1E15 to 1E17/cm², and the doping element is nitrogen.

9. The silicon carbide epitaxial wafer according to any one of claims 1 to 8, wherein the thickness of the second doped silicon carbide epitaxial layer is 2.0 to 25.0 µm, the doping concentration is 1E15 to 1E17/cm², and the doping element is nitrogen.

10. A method for preparing silicon carbide epitaxial wafers, wherein the method comprises the following steps,
1) depositing doped silicon carbide on a silicon carbide substrate by vapor deposition to form a first doped silicon carbide epitaxial layer;
2) in-situ etching the surface of the first doped silicon carbide epitaxial layer in a hydrogen atmosphere to form pits at surface defects;
3) depositing intrinsic silicon carbide on the surface of the first doped silicon carbide epitaxial layer after etching by vapor deposition;
4) removing the intrinsic silicon carbide outside the pit;
5) depositing doped silicon carbide by vapor deposition to form a second doped silicon carbide epitaxial layer.

11. The method according to claim 10, wherein the method further comprises: before forming the first doped silicon carbide epitaxial layer, depositing doped silicon carbide on the silicon carbide substrate by vapor deposition to form a doped silicon carbide buffer layer.

12. The method according to claim 11, wherein the method further comprises: after forming the doped silicon carbide buffer layer, depositing original doped silicon carbide on the silicon carbide substrate by vapor deposition, and performing pyrolysis on the surface of the original doped silicon carbide away from the doped silicon carbide buffer layer at a temperature of 1400 to 1600°C to form a graphene layer, and forming a third doped silicon carbide epitaxial layer on the original doped silicon carbide that has not been subjected to high-temperature pyrolysis.

13. The method according to claim 11 or 12, wherein the thickness of the doped silicon carbide buffer layer is 0.5 to 3.0µm, the doping concentration is 5E17 to 5E18/cm², and the doping element is nitrogen.

14. The method according to claim 12 or 13, wherein the thickness of the third doped silicon carbide epitaxial layer is 1.0 to 20.0µm, the doping concentration is 1E15 to 1E17/cm², and the doping element is nitrogen.

15. The method according to any one of claims 12 to 14, wherein the graphene layer is a graphene layer with 2 to 10 atomic layers.

16. The method according to any one of claims 10 to 15, wherein the thickness of the first doped silicon carbide epitaxial layer is 3.0 to 30.0 µm, the doping concentration is 1E15 to 1E17/cm², and the doping element is nitrogen.

17. The method according to any one of claims 10 to 16, wherein the thickness of the second doped silicon carbide epitaxial layer is 2.0 to 25.0 µm, the doping concentration is 1E15 to 1E17/cm², and the doping element is nitrogen.

18. The method according to any one of claims 10 to 17, wherein in step 2), the etching time is 5 to 20 minutes.

19. The method according to any one of claims 10 to 18, wherein in step 4), in-situ hydrogen etching or chemical polishing is used to remove intrinsic silicon carbide outside the pits.

20. The method according to any one of claims 10 to 19, wherein the conditions for vapor deposition include a temperature of 1500 to 1700°C and a pressure of 50 to 200mbar.

21. A use of the silicon carbide epitaxial wafer according to any one of claims 1 to 10 in the preparation of silicon carbide power devices.
